Europäisches Patentamt

European Patent Office

Office européen des brevets

(11) Veröffentlichungsnummer: **0 425 056 A1**

# (12) EUROPÄISCHE PATENTANMELDUNG

(21) Anmeldenummer: 90202845.5

(22) Anmeldetag: 25.10.90

(51) Int. Cl.⁵: **C23C 16/26**, C23C 16/32, C23C 16/44

(30) Priorität: 27.10.89 DE 3935865

(43) Veröffentlichungstag der Anmeldung:
02.05.91 Patentblatt 91/18

(84) Benannte Vertragsstaaten:
**DE FR GB**

(71) Anmelder: **Philips Patentverwaltung GmbH
Wendenstrasse 35 Postfach 10 51 49
W-2000 Hamburg 1(DE)**

(84) **DE**

Anmelder: **N.V. Philips' Gloeilampenfabrieken
Groenewoudseweg 1
NL-5621 BA Eindhoven(NL)**

(84) **FR GB**

(72) Erfinder: **Bringmann, Udo
Schulstrasse 18
W-2083 Halstenbek(DE)**
Erfinder: **Klages, Claus-Peter, Dr.
Kanalstrasse 18
W-2000 Hamburg 76(DE)**
Erfinder: **Six, Rolf
Am Trotz 9
W-2359 Hennstedt-Ulzburg(DE)**
Erfinder: **Schäfer, Lothar, Dr.
Pinneberger Chaussee 69b
W-2000 Hamburg 54(DE)**

(74) Vertreter: **Nehmzow-David, Fritzi-Maria et al
Philips Patentverwaltung GmbH
Wendenstrasse 35 Postfach 10 51 49
W-2000 Hamburg 1(DE)**

(54) Verfahren zur Abscheidung mikrokristalliner Festkörperpartikel aus der Gasphase mittels Chemical Vapour Deposition (CVD).

(57) Verfahren zur Abscheidung mikrokristalliner Festkörperpartikel aus einer Kohlenstoff-haltige Gase enthaltenden Gasphase mittels Chemical Vapour Deposition (CVD), bei dem die abzuscheidenden Festkörperpartikel bei einem Druck im Bereich von $10^{-5}$ bis 1 bar an einem, auf eine Temperatur im Bereich von 450 bis 1200 °C aufgeheizten Substrat abgeschieden werden und bei dem die chemischen Gasphasenreaktionen in der thermisch durch einen Widerstandsheizleiter angeregten Gasphase erfolgen, wobei ein aus einem Carbid mindestens eines Übergangsmetalls aus den Nebengruppen IVa bis des Periodischen Systems der Elemente (PSE) mit einem einer stöchiometrischen Zusammensetzung mindestens nahezu entsprechenden Gehalt an gebundenem Kohlenstoff und mit einem Schmelzpunkt > 2000 °C hergestellter Widerstandsheizleiter eingesetzt wird.

EP 0 425 056 A1

# VERFAHREN ZUR ABSCHEIDUNG MIKROKRISTALLINER FESTKÖRPERPARTIKEL MITTELS CHEMISCHER GASPHASENABSCHEIDUNG.

Die Erfindung betrifft ein Verfahren zur Abscheidung mikrokristalliner Festkörperpartikel aus einer Kohlenstoff-haltige Gase enthaltenden Gasphase mittels chemischer Gasphasenabscheidung (CVD), bei dem die abzuscheidenden Festkörperpartikel bei einem Druck im Bereich von $10^{-5}$ bis 1 bar an einem, auf eine Temperatur im Bereich von 450 bis 1200 °C aufgeheizten Substrat abgeschieden werden und bei dem die chemischen Gasphasenreaktionen in der thermisch durch einen Widerstandsheizleiter angeregten Gasphase erfolgen.

Die Abscheidung mikrokristalliner Festkörper aus der Gasphase mittels CVD wird für breite Anwendungsbereiche benutzt für die Herstellung von freitragenden Formkörpern oder auch zur Ausbildung von Beschichtungen auf unterschiedlichsten Substraten.

Ganz allgemein ist für einen CVD-Prozeß charakteristisch, daß eine Mischung von Gasen bei einer relativ hohen Temperatur mit einer Substratoberfläche in Wechselwirkung tritt unter Zersetzung mindestens eines am Gasgemisch beteiligten Gases und Abscheidung eines Raktionsproduktes in fester Phase an der Substratoberfläche. Der konventionelle CVD-Prozeß bedingt hohe Temperaturen, reaktive Gase und eine für die Durchführung eines solchen Verfahrens geeignete Vorrichtung. Typische Prozeßparameter sind Temperaturen im Bereich von 450 bis zu 2500 °C, Drucke im Bereich von $10^{-5}$ bis 1 bar und ein Prozeßgasgemisch aus mindestens einem reaktiven Gas und weiteren Gasen wie inerten, oxidierenden oder reduzierenden Gasen.

Die Reaktionsprodukte (Festkörperpartikel) werden dementsprechend erhalten durch
Pyrolyse (z.B.: $CH_3SiCl_3 \rightarrow SiC + 3HCl$) oder
Reduktion (z.B.: $WF_6 + 3H_2 \rightarrow W + 6HF$) oder
Oxidation (z.B.: $SiH_4 + O_2 \rightarrow SiO_2 + 2H_2$) oder
Coreduktion (z.B.: $TiCl_4 + 2BCl_3 + 5H_2 \rightarrow TiB_2 + 10HCl$).

For Aktivierung des Prozeßgasgemisches innerhalb des Reaktors erfolgt in einer Anregungszone (Gasphasenbereich mit maximalem Energieinhalt), die beispielsweise über ein Plasma, das durch Einkopplung von Mikrowellen- oder Hochfrequenz-Energie oder Energie aus einem elektrischen Gleichspannungsfeld, über einen durch Stromdurchgang beheizten Draht oder über eine Flamme erzeugt werden kann. In der Anregungszone werden die Gasphasenreaktionen stimuliert und eine Abscheidung der Reaktionsprodukte erfolgt anschließend auf dem vorzugsweise in einem Abstand zur Anregungszone positionierten Substrat, das auf einem üblicherweise temperaturgeregelten Substrathalter angeordnet ist. Die Restgase werden mittels einer Vakuumpumpe aus dem Reaktor abgepumpt.

Aus Jap. J. Appl. Phys. 21 (1982), Nr. 4, Seiten L183 bis L185 ist in Fig. 1 schematisch eine Vorrichtung zur Abscheidung von Diamantpartikeln mittels CVD aus einer Methan/Wasserstoff-Gasphase bekannt, in welcher das Reaktionsgasgemisch durch einen Widerstandsheizleiter in Form einer Wolframwendel einer Temperatur von etwa 2000 °C aktiviert wird.

Bei Versuchen, die im Rahmen der Erfindung zur Abscheidung von polykristallinen Diamantschichten mittels eines thermischen CVD-Prozesses durchgeführt wurden, hat sich gezeigt, daß das Material des Widerstandsheizleiters (vorzugsweise Molybdän, Wolfram oder Tantal) unter Prozeßbedingungen (Kohlenwasserstoffgas/Wasserstoff-Atmosphäre, Temperaturen über 2000 °C) innerhalb kürzester Zeit (etwa nach 10 h Prozeßdauer) verspröden und spontan oder bei einer leichten Erschütterung oder Berührung zerbrechen. Aus EP-A2 272 418 sind beispielsweise ein derartiges Verfahren und eine dafür geeignete Vorrichtung bekannt. Hierbei werden Diamantpartikel aus einer Kohlenstoff/Wasserstoff-Atmosphäre mittels eines thermischen CVD-Prozesses an einem auf eine Temperatur im Bereich von 1000 bis 2500 °C aufgeheizten Substrat aus einem hochschmelzenden Metall oder aus Kohlenstoff abgeschieden, wobei das Reaktionsgas mittels eines Wolframheizleiters einer Temperatur von 2000 °C angeregt wird.

Wegen seiner Einfachheit ist das Verfahren, bei dem die Gasphase über einen aufgeheizten Widerstandsdraht angeregt wird (in der Fachliteratur auch als "Filamentverfahren" bezeichnet), heute einer der am häufigsten eingesetzten Prozesse zur Herstellung von Diamantschichten. Die lineare Wachstumsgeschwindigkeit liegt in der Größenordnung von 1 μm/h, wenn als Kohlenstoff-haltiges Gas Methan eingesetzt wird. Die Abscheidungsgeschwindigkeit kann etwa um eine Größenordnung gesteigert werden, wenn für das Reaktionsgasgemisch andere organische Verbindungen als Kohlenstofflieferanten eingesetzt werden, z.B. Alkohole, Äther, Ketone, Amine. Es hat sich bei diesen Prozessen jedoch gezeigt, daß eine kontinuierliche Prozeßdauer von etwa 10 h kaum überschritten werden kann, weil die üblicherweise eingesetzten Widerstandsheizleiter aus hochschmelzenden Metallen wie Wolfram, Molybdän oder Tantal während dieser Prozeßdauer - wie oben bereits beschrieben wurde - verspröden.

Diese Versprödung ist darauf zurückzuführen, daß die Metalle der Widerstandsheizleiter mit der reaktiven Gasphase chemisch reagieren unter Carbidbildung, und die damit verbundenen Gefügeänderungen der Widerstandsheizleiter führen dann zu der nicht erwünschten mechanischen Instabilität. Bei Einsatz von Widerstandsheizleitern aus hochschmelzenden Metallen ist es daher erforderlich, diese nach relativ kurzer Prozeßdauer auszuwechseln, der Abscheideprozeß muß also unterbrochen werden und es ist nur schwierig möglich, homogene Festkörperpartikelschichten einer größeren Dikke (> 100 μm) in einem kontinuierlichen Prozeß oder mehrere dünne Festkörperpartikelschichten nacheinander ohne Auswechseln des Widerstandsheizleiters herzustellen.

Der Erfindung liegt die Aufgabe zugrunde, das eingangs genannte Verfahren zur Abscheidung mikrokristalliner Festkörperpartikel aus einer Kohlenstoff-haltige Gase enthaltenden Gasphase mittels CVD so zu verbessern, daß eine längere kontinuierliche Prozeßdauer erreicht werden kann, ohne den Widerstandsheizleiter auswechseln zu müssen.

Diese Aufgabe wird erfindungsgemäß dadurch gelöst, daß ein aus einem Carbid mindestens eines Übergangsmetalls aus den Nebengruppen IVa bis VIa des Periodischen Systems der Elemente (PSE) mit einem einer stöchiometrischen Zusammensetzung mindestens nahezu entsprechenden Gehalt an gebundenem Kohlenstoff und mit einem Schmelzpunkt > 2000 °C hergestellter Widerstandsheizleiter eingesetzt wird.

Nach einer vorteilhaften Weiterbildung des erfindungsgemäßen Verfahrens wird ein Widerstandsheizleiter eingesetzt, der aus einem Carbid oder einem Mischcarbid der Übergangsmetalle Titan, Zirkon, Hafnium, Vanadium, Niob, Tantal, Molybdän und/oder Wolfram hergestellt ist.

Die Herstellung von Carbiden hochschmelzender Metalle aus den Nebengruppen IVa bis VIa des PSE wie auch ihre Weiterverarbeitung sind bekannt (vgl. hierzu Ullmanns Encyklopädie der technischen Chemie, 3. Auflage 1954) . Beachtlich ist jedoch, daß Carbide als Ausgangsmaterial für den Widerstandsheizleiter eingesetzt werden, die einen Gehalt an gebundenem Kohlenstoff haben, der der stöchiometrischen Zusammensetzung mindestens nahezu, wenn möglich vollständig entspricht. Insbesondere durch heißisostatisches Pressen von derartigen Carbidpulvern lassen sich mechanisch außerordentlich stabile Formkörper einer Dichte von mindestens 88% herstellen, die nach dem Pressen einem weiteren mechanischen Bearbeitungsschritt unterzogen werden können, so daß Widerstandsheizleiter einer geeigneten gewünschten Formegebung ohne Schwierigkeiten hergestellt werden können. Es ist selbstverständlich auch möglich, andere aus der Pulvermetallurgie bekannte Verformungstechniken für die Herstellung der Widerstandsheizleiter einzusetzen.

Nach weiteren vorteilhaften Ausgestaltungen des erfindungsgemäßen Verfahrens werden als Festkörperpartikel Carbide oder Diamantkristallite abgeschieden.

Diamantkristallite können nach weiteren vorteilhaften Ausgestaltungen des Verfahrens gemäß der Erfindung aus einer Wasserstoff und < 30% eines Kohlenstoff-haltigen Gases, vorzugsweise Kohlenwasserstoffgase wie Methylgruppen enthaltende Kohlenwasserstoffgase, abgeschieden werden.

Mit der Erfindung sind die Vorteile verbunden, daß bei Einsatz eines Widerstandsheizleiters gemäß der Erfindung nicht nur CVD-Abscheideprozesse einer kontinuierlichen Prozeßdauer von mehr als 10 Stunden durchgeführt werden können, mit denen dann homogene Schichten aus den abgeschiedenen Festkörperpartikeln entsprechend größerer Dicke erreicht werden können, sondern die Prozesse können insgesamt auch kostengünstiger durchgeführt werden, weil es aufgrund der verlängerten Lebensdauer der Widerstandsheizleiter nicht so häufig erforderlich ist, den Widerstandsheizleiter auszuwechseln, wie es bei den bekannten Verfahren unter Einsatz einer Wendel aus hochschmelzendem, jedoch mit der reaktiven Gasphase chemisch reagierendem Metall (z.B. aus Wolfram, Molybdän oder Tantal) erforderlich ist.

Ein weiterer Vorteil ist, daß Widerstandsheizleiter aus Carbiden oder Mischcarbiden mittels aller aus der Pulvermetallurgie bekannter Fertigungsprozesse hergestellt werden können. Widerstandsheizleiter aus z.B. durch heißisostatisches Pressen verformten Carbiden sind mechanisch außerordentlich stabil und können eine beliebige gewünschte, insbesondere großflächige Form haben, so daß mit ihnen eine entsprechend großflächige gleichmäßige Beheizung der Anregungszone in einem CVD-Reaktor erfolgen kann.

Als Ausführungsbeispiel wird die Anwendung eines durch einen Sinterprozeß hergestellten Widerstandsheizleiters aus Wolframcarbid in einem CVD-Prozeß zur Abscheidung polykristalliner Diamantpartikel auf einem Substrat aus Wolfram beschrieben.

Ein aus Wolframcarbid durch einen Sinterprozeß hergestellter Widerstandsheizleiter eines Durchmessers von 1 mm und einer Länge von 50 mm wird zunächst zur Entfernung von Fremdstoffen über eine Dauer von 3 Stunden in einem Gasgemisch aus 1% Methan und 99% Wasserstoff bei einem Druck von etwa 66 mbar durch direkten Stromdurchgang auf eine Temperatur von 2500 °C erhitzt, wobei Binde- und/oder Sinterhilfsmittel sowie flüchtige Verunreinigungen aus dem Widerstandsheizleiter entfernt werden. Anschließend wird der Widerstandsheizleiter in einem CVD-Reaktr zur Abscheidung von polykristallinem Diamant anstelle der üblicherweise verwendeten Heizwendel aus einem hochschmelzenden Metall installiert. Mit einem Widerstandsheizleiter aus Wolframcarbid wurden bei CVD-Prozessen zur Abscheidung von polykristallinen Diamantschichten dieselben Ergebnisse (z.B. Abscheidungsgeschwindigkeit, Morphologie) erreicht, wie unter Einsatz eines gewendelten Tantaldrahtes zur Anregung der Reaktionsgasphase. Mit einem Widerstandsheizleiter aus Wolframcarbid wurden mindestens 12 Abscheideprozesse einer Dauer von durchschnittlich jeweils 7 h durchgeführt, ohne daß der Heizleiter seine mechanische Stabilität eingebüßt hätte. Tantaldrähte zeigten bereits nach einer Prozeßdauer von 10 h unter gleichen Bedingungen eine solche Versprödung, daß sie bei geringster mechanischer Erschütterung zerbrachen.

Der Abscheideprozeß wurde mit folgenden Parametern durchgeführt:
Prozeßgasgemisch: 0,5% Methan in Wasserstoff;
Arbeitstemperatur des Widerstandsheizleiters: 2200 °C;
Gesamtdurchsatz des Prozeßgasgemisches: 200 Standard-cm³/min;
Gesamtdruck im Reaktor: 40 mbar;
Temperatur der Substratoberfläche: 850 °C;
Dicke der abgeschiedenen Diamantschicht nach einer kontinuierlichen Prozeßdauer von 7 h: 5 μm.

**Ansprüche**

1. Verfahren zur Abscheidung mikrokristalliner Festkörperpartikel aus einer Kohlenstoff-haltige Gase enthaltenden Gasphase mittels chemischer Gasphasenabscheidung (CVD), bei dem die abzuscheidenden· Festkörperpartikel bei einem Druck im Bereich von $10^{-5}$ bis 1 bar an einem, auf eine Temperatur im Bereich von 450 bis 1200 °C aufgeheizten Substrat abgeschieden werden und bei dem die chemischen Gasphasenreaktionen in der thermisch durch einen Widerstandsheizleiter angeregten Gasphase erfolgen,
dadurch gekennzeichnet,
daß ein aus einem Carbid mindestens eines Übergangsmetalls aus den Nebengruppen IVa bis VIa des Periodischen Systems der Elemente (PSE) mit einem einer stöchiometrischen Zusammensetzung mindestens nahezu entsprechenden Gehalt an gebundenem Kohlenstoff und mit einem Schmelzpunkt > 2000 °C hergestellter Widerstandsheizleiter eingesetzt wird.

2. Verfahren nach Anspruch 1,
dadurch gekennzeichnet,
daß als Festkörperpartikel Carbide abgeschieden werden.

3. Verfahren nach Anspruch 1,
dadurch gekennzeichnet,
daß als Festkörperpartikel Diamantkristallite abgeschieden werden.

4. Verfahren nach Anspruch 3,
dadurch gekennzeichnet,
daß die Diamantkristallite aus einer Wasserstoff und < 30% eines Kohlenstoff-haltigen Gases enthaltenden Gasphase an dem Substrat abgeschieden werden.

5. Verfahren nach Anspruch 4,
dadurch gekennzeichnet,
daß als Reaktionsgas Wasserstoff mit einem Zusatz von 0,5% eines Kohlenwasserstoffgases eingesetzt wird.

6. Verfahren nach Anspruch 5,
dadurch gekennzeichnet,
daß als Kohlenwasserstoffgas Methylgruppen enthaltende Kohlenwasserstoffgase eingesetzt werden.

7. Verfahren nach Anspruch 6,
dadurch gekennzeichnet,
daß als Kohlenwasserstoffgas Methan eingesetzt wird.

8. Verfahren nach mindestens einem der Ansprüche 1 bis 7,
dadurch gekennzeichnet,
daß ein Widerstandsheizleiter eingesetzt wird, der aus einem Carbid oder einem Mischcarbid der Übergangsmetalle Titan, Zirkonium, Hafnium, Vanadium, Niob, Tantal, Molybdän und/oder Wolfram hergestellt ist.

**Europäisches Patentamt**

# EUROPÄISCHER RECHERCHENBERICHT

Nummer der Anmeldung

**EP 90 20 2845**

## EINSCHLÄGIGE DOKUMENTE

| Kategorie | Kennzeichnung des Dokuments mit Angabe, soweit erforderlich, der maßgeblichen Teile | Betrifft Anspruch · | KLASSIFIKATION DER ANMELDUNG (Int. Cl.5) |
|---|---|---|---|
| Y | PATENT ABSTRACTS OF JAPAN, Band 12, Nr. 230 (C-508)[3077], 29. Juni 1988; & JP-A-63 25 296 (TOSHIBA) 02-02-1988 * Zusammenfassung * | 1,3,4,6-8 | C 23 C 16/26 C 23 C 16/32 C 23 C 16/44 |
| Y,D | EP-A-0 272 418 (GENERAL ELECTRIC) * Seite 8, Beispiel 1 * | 1,3,4,6-8 | |

– – –

– – – – –

|  |  |
|---|---|
| | **RECHERCHIERTE SACHGEBIETE (Int. Cl.5)** |
| | C 23 C |

Der vorliegende Recherchenbericht wurde für alle Patentansprüche erstellt

| Recherchenort | Abschlußdatum der Recherche | Prüfer |
|---|---|---|
| Den Haag | 31 Januar 91 | PATTERSON A.M. |